Europäisches Patentamt

European Patent Office

Office européen des brevets

(19)

(11) Veröffentlichungsnummer: **0 004 259**
**B1**

# (12) EUROPÄISCHE PATENTSCHRIFT

(45) Veröffentlichungstag der Patentschrift: **20.01.82**

(21) Anmeldenummer: **78101089.7**

(22) Anmeldetag: **06.10.78**

(51) Int. Cl.³: **G 01 R 15/07, G 02 F 1/09**

(54) **Anordnung zur magnetooptischen Strommessung und Verfahren zum Betrieb der Anordnung.**

(30) Priorität: **29.12.77 DE 2758611**

(43) Veröffentlichungstag der Anmeldung:
**03.10.79 Patentblatt 79/20**

(45) Bekanntmachung des Hinweises auf die Patenterteilung:
**20.01.82 Patentblatt 82/3**

(84) Benannte Vertragsstaaten:
**CH FR GB**

(56) Entgegenhaltungen:
**CH - A - 441 814**
**DE - B - 2 042 559**
**DE - A - 2 232 979**
**DE - A - 2 261 953**

(73) Patentinhaber: **SIEMENS AKTIENGESELLSCHAFT**
**Berlin und München**
**Postfach 22 02 61**
**D-8000 München 22 (DE)**

(72) Erfinder: **Papp, Alfred, Dr.**
**Winternitzstrasse 6**
**D-8000 München (DE)**
Erfinder: **Harms, Hauke**
**Annette-Kolb-Anger 11**
**D-8000 München (DE)**

Courier Press, Leamington Spa, England.

Anordnung zur magnetooptischen Strommessung und Verfahren zum Betrieb der Anordnung

Die Erfindung bezieht sich auf eine Anordnung zur magnetooptischen Strommessung in der der zu messende Strom eine Drehung der Polarisationsebene des linear polarisierten Lichtstrahls erzeugt, der in Teilstrahlen mit zueinander senkrechten Polarisationsrichtungen aufgeteilt wird.

Es sind Meßeinrichtungen für Ströme in Hochspannungsleitern und für große Wechselströme mit Gleichstromglied bekannt, bei denen ein Lichstrahl über einen Polarisator, einen magnetooptischen Messfühler sowie einen Analysator einem Detektor zugeführt wird, dem eine Elektronik nachgeschaltet ist. Die Polarisationsebene des Lichtstrahls erhält in dem vom magnetischen Feld des zu messenden Stromes beeinflußten Messfühler eine der Größe des Stromes entsprechende Drehung. In einer auf Niederspannungspotential angeordneten Auswerteeinrichtung wird im Analysator die Größe der Drehung in ein entsprechendes Intensitätssignal umgewandelt, das vom Photodetektor erfaßt werden kann. Das Ausgangssignal des Detektors wird in der Elektronik verarbeitet.

In einer bekannten Anordnung (DE—C— 2 130 047) enthält die Auswerteeinrichtung einen Analysator, in dem das vom Messfühler kommende Licht in zwei Teillichtstrahlen aufgespalten wird, deren Polarisationsebenen senkrecht aufeinander stehen und die ihre Intensität mit dem Drehwinkel der Polarisationsebene des einfallenden Strahles gegenläufig ändern. Die beiden Teillichtstrahlen werden jeweils einem Detektor zugeführt, die vorzugsweise Halbleiterphotodioden sein können und denen ein Differenzverstärker nachgeschaltet ist. Die Differenzspannung dient als Maß für die Faraday-Drehung des Meßsignals. Mit diesem Verfahren können die Rauschanteile des Meßsignals eliminiert werden, die durch Intensitätsschwankungen des Lichtstrahls, vorzugsweise eines Laserstrahls, verursacht werden. Die verwendeten Photodioden haben aber eine geringe Streuung ihrer Empfindlichkeit. Außerdem ist es in einem technischen Aufbau unvermeidlich, daß die Laserstrahlen auf den Halbleiterphotodioden örtlich schwanken. Diese Dioden haben eine herstellungsbedingte Ortsabhängigkeit ihrer Photoempfindlichkeit. Strahlverlagerungen von wenigen μm können Signalschwankungen bis zu mehreren Prozent verursachen. Die den beiden Teilstrahlen zugeordneten Detektoren liefern somit unterschiedliche Signalschwankungen, die mit dem bekannten Differential-Meßverfahren nicht eliminiert werden können.

Ein weiteres bekanntes Verfahren (Rogers in "Optical Methods for Measurement of Voltage and Current at High Voltage", A.I.M., Leige, Traitment des donnees — 1977, Seite 6, Abschnitt 3.2 (c), Intensity Distribution Noise) arbeitet deshalb mit einem modulierten Lichtstrahl, der über den Meßfühler und einen Analysator einer einzigen Photodiode zugeführt wird, deren Ausgangssignal in einer Elektronik verarbeitet wird.

Der Detektor erfaßt die Intensität des ankommenden Meßsignals, das noch das überlagerte Modulationssignal enthält. Die Demodulation erfolgt in der nachgeschalteten Elektronik. Die Intensität wird sowohl durch die Faraday-Drehung im Meßfühler als auch durch die Rauschanteile, nämlich die Intensitätsschwankungen der Strahlungsquelle, sowie Intensitätsschwankungen, die durch mechanische Schwingungen der optischen Komponenten im Strahlengang verursacht werden, und außerdem durch Empfindlichkeit der Photodiode selbst beeinflußt. Mit diesem Meßverfahren können beide Intensiätskomponenten voneinander getrennt werden und der Rauschanteil arn Meßsignal wird unterdrückt. Die Linearität zwischen Nutz- und Meßsignal ist aber nur bei kleinen Drehwinkeln bis zu etwa 2° ausreichend. Bei größeren Drehwinkeln mit entsprechend größerem Signal-Rauschverhältnis ergibt sich eine von der Signalamplitude abhängige Nichtlinearität.

Der Erfindung liegt nun die Aufgabe zugrunde, eine Meßanordnung für sehr genaue Messung mit einem Meßfehler von beispielsweise weniger als 0,2% zu schaffen, die eine wesentlich größere Drehung der Polarisationsebene zuläßt.

Diese Aufgabe wird mit einer Anordnung der eingangs genannten Art erfindungsgemäß dadurch gelöst, daß in einem Teillichtstrahl ein Lichtablenker angeordnet ist, der den Teillichtstrahl mit einer bestimmten Frequenz abwechselnd durchlässt oder auf einen Detektor lenkt, der direkt im anderen Teillichtstrahl angeordnet ist, und dass elektronische Mittel zur Bildung des Quotienten aus dem Detektorsignal des direkt auf den Detektor auftreffenden Teillichtstrahles und dem darauf folgenden Detektorsignal der Summe der Teillichtstrahlen vorgesehen sind, welche ein vom Rauschanteil im optischen Signal befreites Messsignal erzeugen. Die Schaltfrequenz soll mindestens eine Größenordnung, vorzugsweise wenigstens zwei Größenordnungen und insbesondere etwa drei Größenordnungen höher als die Signalfrequenz sein. Der Detektor erhält somit jeweils abwechselnd die Intensität eines Teillichtstrahls die Summe der Intensitäten beider Teillichtstrahlen.

Zur weiteren Erläuterung der Erfindung wird auf die Zeichnung Bezug genommen, in deren Fig. 1 ein Ausführungsbeispiel einer Meßanordnung nach der Erfindung schematisch veranschaulicht ist. Figur 2 zeigt die Zuordnung der Teillichtstrahlen, und in Figur 3 ist ein Ausführungsbeispiel einer Elektronik dargestellt.

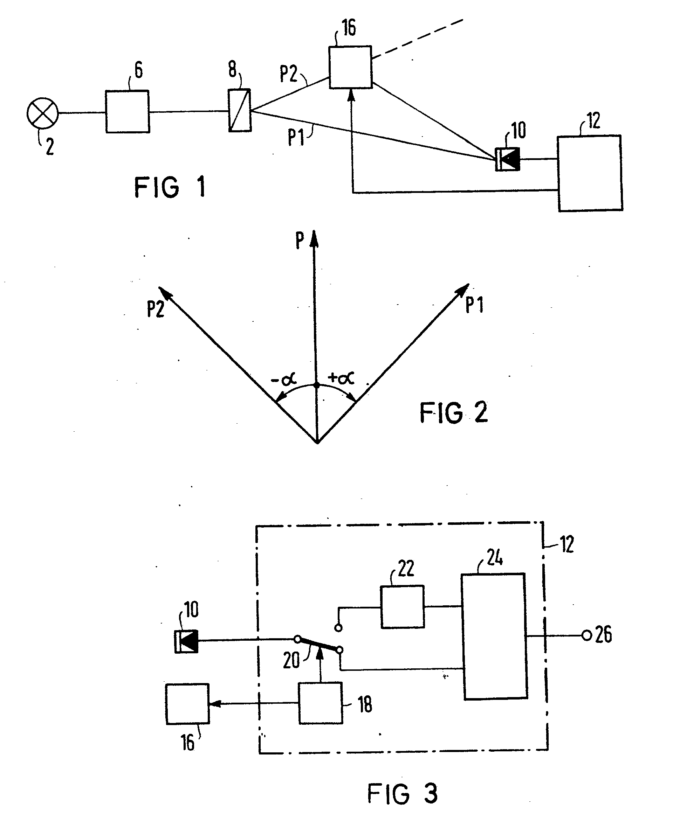

In Fig. 1 ist eine Strahlungsquelle mit 2, ein Meßfühler mit 6, ein Analysator mit 8 und ein Detektor mit 10 bezeichnet. Dem Detektor 10 ist eine Elektronik 12 nachgeschaltet. Ferner enthält die Anordnung einen Lichtablenker 16. Die Strahlungsquelle 2 liefert einen nicht näher bezeichneten Strahl linear polarisierten Lichts, vorzugsweise einen Laserstrahl, dessen Polarisationsrichtung im Meßfühler 6 in Abhängigkeit von der Größe eines Magnetfeldes gedreht wird, das einen in der Figur nicht dargestellten elektrischen Leiter umgibt, vorzugsweise einen Hochspannungsleiter, dessen Strom gemessen werden soll. Der Analysator 8 wirkt als Polarisationsstrahlteiler und kann vorzugsweise aus einem Analysatorprisma bestehen, das unter der Bezeichnung Wollastonprisma bekannt ist. Solche Analysatoren enthalten mehrteilige Prismen aus Kalkspat oder Quarz. Außerdem kann auch ein Polarisationsstrahlteiler nach Foster verwendet werden. In dem Analysator 8 werden zwei getrennte Teillichtstrahlen P1 und P2, deren Polarisationsrichtungen senkrecht aufeinander stehen, d.h. einen Winkel von 90° einschließen, gebildet. Der Teilstrahl P2 trifft auf den Lichtablenker 16 und wird von diesem jeweils abwechselnd mit hoher Schaltfrequenz $f_m$ entweder durchgelassen, wie es in der Figur gestrichelt angedeutet ist, oder auf den Detektor 10 abgelenkt. Der Detektor 10 erhält somit jeweils abwechselnd mit der Schaltfrequenz $f_m$ von beispielsweise 50 kHz, die weit über der Signalfrequenz von beispielsweise 50 Hz liegt, den Teillichtstrahl P1 mit der einen Polarisationsrichtung und anschließend die Summe beider Teillichtstrahlen P1 und P2.

Wenn (ohne Messfühlersignal) die Polarisationsrichtung P des linear polarisierten Lichtstrahls mit den senkrecht aufeinander stehenden Polarisationsrichtungen der beiden Teillichtstrahlen P1 und P2 jeweils einen positiven bzw. negativen Winkel $\alpha$ von 45° einschliesst, erzeugt der Detektor 10 zugeführte Teillichtstrahl P1 ($\alpha = +45°$) das Detektorsignal.

$$D_- = \frac{p(t) \cdot I(t)}{2} [1 - \sin 2 F(t)]$$

mit p(t) als Empfindlichkeit des Detektors, I(t) als Intensität des Lichtstrahls und F(t) als Faraday-Drehmeßsignal.

Dieses Signal erhält der Detektor 10 solange der Lichtablenker 16 seinen Teillichtstrahl P2 durchläßt. Sobald der Lichtablenker 16 seinen Teillichtstrahl P2 auf den Detektor 10 lenkt, erhält dieser auch noch das zusätzliche Detektorsignal

$$D_+ = \frac{p(t) \cdot I(t)}{2} [1 + \sin 2 F(t)]$$

Das Detektorsignal besteht somit während dieser Zeit aus der Summe der einzelnen Detektorsignale und man erhält

$$D_+ + D_- = p(t) \cdot I(t)$$

das dem reinen Rauschanteil des Meßsignals entspricht. Der Detektor 10 gibt somit im Takt der Schaltfrequenz $f_m$ jeweils abwechselnd das gesamte Meßsignal mit der Drehung und dem Rauschanteil und anschließend nur den reinen Rauschanteil ab.

In entsprechender Weise kann der Teillichtstrahl P2 direkt auf den Detektor 10 gelenkt und der andere Teillichtstrahl P1 im Takt der Schaltfrequenz $f_m$ dem Detektor 10 zusätzlich zugeführt werden.

In der Elektronik 12 nach Figur 3 wird das Ausgangssignal des Detektors 10 im Takt der von einem Taktgeber 18 vorgegebenen Schaltfrequenz $f_m$ des Lichtablenkers über einen elektronischen Umschalter 20 jeweils abwechselnd einem elektronischen Speicher 22 und einem elektronischen Rechner 24 vorgegeben. Der Speicher 22, der beispielsweise nach dem Prinzip "sample — and — hold" arbeitet, erhält beispielsweise das Detektorsignal D_, speichert es und gibt es während des anschließenden Zeitintervalls nach der Umschaltung des Schalters 20 an den Rechner 24 weiter, dem das Summensignal $D_+ + D_-$ während dieser Zeit direkt zugeführt wird.

Der Rechner 24 bildet den Quotienten aus dem Detektorsignal D_ und dem Detektorsignal $D_+ + D_-$ der Summe der Teillichtstrahlen P1 und P2 und man erhält am Ausgang 26 das Signal

$$U_{26} = \frac{D_-}{D_+ + D_-} = \frac{1}{2} \cdot [1 - \sin 2 F(t)]$$

Den konstanten Faktor 1 kann man beispielsweise durch elektronische Filterung eliminieren, und den Sinus kann man in bekannter Weise mit einem elektrischen Arcussinus-Baustein linearisieren.

**Patentansprüche**

1. Anordnung zur magnetooptischen Stommessung, in der der zu messende Strom eine Drehung der Polarisationsebene eines linear polarisierten Lichtstrahls erzeugt, der in einem Analysator in zwei Teillichtstrahlen mit zueinander senkrechten Polarisationsrichtungen zerlegt wird, dadurch gekennzeichnet, daß in einem Teillichtstrahl (P2) ein Lichtablenker (16) angeordnet ist, der den Teillichtstrahl (P2) abwechselnd durchlässt oder auf einen Detektor (10) lenkt, der direkt im anderen Teillichtstrahl (P1) angeordnet ist und daß elektronische Mittel zur Bildung des Quotienten aus dem Detektorsignal des direkt auf dem Detektor auftrettenden Teillichtstrahles und dem darauf folgenden Detektorsignal der Summe der Teillichtstrahlen vorgesehen sind, welche ein vom Rauschanteil im optischen Signal betreites Messignal erzeugen.

2. Anordnung nach Anspruch 1, dadurch gekennzeichnet, daß als Analysator (8) ein Wollastonprisma vorgesehen ist.

3. Verfahren zum Betrieb der Anordnung nach Anspruch 1 oder 2, dadurch gekennzeichnet, dass die Umschaltfrequenz (fm) des Lichtablenkers wesentlich größer als die Frequenz des zu messenden Stromes gewählt wird.

## Revendications

1. Dispositif magnéto-optique, pour la mesure d'un courant, dans lequel le courant à mesurer provoque une rotation du plan de polarisation d'un rayon lumineux polarisé linéairement, qui est décomposé dans un analyseur en deux rayons lumineux partiels dont les directions de polarisation sont perpendiculaires entre elles, caractérisé en ce que dans la trajectoire de l'un des rayons lumineux partiels (P2) est placé un déviateur de lumière (16) qui, alternativement, liasse passer le rayon partiel (P2) ou le dévie sur un détecteur (10) placé directement dans la trajectoire de l'autre rayon lumineux partiel (P1), et qu'il est prévu des moyens électroniques pour former le quotient du signal du détecteur du rayon lumineux partiel arrivant directement sur le détecteur et du signal suivant du détecteur de la somme des rayons lumineux partiels, qui fournissent un signal de mesure exempt de toute composante de bruit dans le signal optique.

2. Dispositif suivant la revendication 1, caractérisé en ce que, comme analyseur (8) il est prévu un prisme de Wollaston.

3. Procédé de mise en oeuvre du dispositif suivant la revendication 1 ou 2, caractérisé en ce que la fréquence de commutation ($f_m$) du déviateur de lumière est nettement plus grande que la fréquence du courant à mesurer.

## Claims

1. A magneto-optical electric current measurement arrangement wherein the current to be measured produces a rotation of the polarisation plane of a linearly polarised light beam which is divided in an analyser into two mutually perpendicular plane-polarised components, characterised in that one component (P2) there is arranged to be incident upon a light deflector (16) which periodically allows the component (P2) to pass or directs the component to a detector (10) which is arranged in the path of the other component (P1), and electronic means serve to form a quotient from the detector signal produced by the component which is directly incident upon the detector and from the following detector signal formed by the sum of the incident components, which electronic means produce a test signal free from any noise content in the optical signal.

2. An arrangement as claimed in claim 1, characterised in that a Wollaston prism is provided as said analyser (8).

3. A method of operation of an arrangement as claimed in claim 1 or 2, characterised in that the change-over frequency ($f_m$) of the light deflector is higher than the frequency of the current which is to be measured.

FIG 1

FIG 2

FIG 3